# EUROPEAN PATENT APPLICATION

(11) **EP 1 898 684 A1**
(43) Date of publication of application: **12.03.2008**
(21) Application number: 07075735.6
(22) Date of filing: 28.08.2007
(51) Int. Cl.: H05K 5/06, H05K 5/00, H01L 23/02, H01L 23/10

(54) **Sealed electronic component**

(30) Priority: 06.09.2006 US 516195
(71) Applicant: Delphi Technologies, Inc., Troy, Michigan 48007 (US)
(72) Inventor: O'Connor, Kurt F., Carmel, IN 46033 (US); Lawlyes, Daniel A., Kokomo, IN 46902 (US); Laudick, David A., Kokomo, IN 46901 (US); Gertiser, Kevin M., Kokomo, IN 46904-6207 (US)
(74) Representative: Denton, Michael John

(57) **Abstract**

An assembly for a sealed electronic component includes at least one electronic device (18) mounted on a substrate (16), and a metal enclosure comprising first and second housing components (12, 14) that are welded together to define a sealed enclosure. The resulting assembly provides a reliable seal that eliminates the need for mechanical fasteners, adhesives, and equipment for applying and curing adhesives.

## Description

### Technical Field

This invention relates to the combination of an electronic component and a housing for the electronic component, in which the housing is sealed to protect the electronic component against water intrusion.

### Background of the Invention

In many applications, it is necessary or at least desirable to protect electronic components from damage due to contact with water, snow or the like. Examples include various electronic devices used in automotive applications, which are mounted on the vehicle in a location exterior of the vehicle cabin, such as under an automobile hood. In such cases, it is necessary or highly desirable that the electronic components are encased in a sealed housing. In the past, such housings comprised a housing base and a cover that is adhesively bonded to the housing base to form an enclosure for the electronic component. In the case of the housing base comprising a metal casting and a cover comprising a stamped sheet metal material, leakage and water intrusion has occurred due to poor adhesion between the casting and the stamped cover. In order to prevent such failure, it is necessary that the bonded surfaces are free of contaminants prior to application of the adhesive composition to the bonding surfaces. Thereafter, the adhesive must be cured, typically for at least at hour in an oven, in order to establish a satisfactory seal between the casting and the stamped cover that will not fail. Accordingly, establishment of a reliable seal between a metal casting and a stamped metal cover using conventional adhesive sealants requires meticulous decontamination of surfaces, maintenance of a contaminant free environment during assembly of the components, and the provision, maintenance and operation of curing ovens. As a result, the development of a reliable seal between a metal casting and a stamped metal cover using adhesives is difficult and expensive.

In order to mitigate the stringent requirements for achieving a reliable seal using adhesives, it has been proposed to supplement the adhesive seal with fasteners, such as screws. However, incorporating fasteners into the structure and driving fasteners during the assembly process are expensive, and do not add value to the product.

In addition to the aforementioned problems, there are electromagnetic compatibility (EMC) issues with the conventional housings comprised of a metal casting and a stamped cover due to poor connection between the cover and the casting. In addition, known methods of grounding a printed circuit board or other substrate on which an electronic component is mounted have not been fully satisfactory.

### Summary of the Invention

Various aspects of the invention, either individually or in combination, overcome one or more of the aforementioned problems with known sealed housings for electronic components.

In accordance with one aspect of the invention, there is provided a sealed electronic component which includes at least one electronic device mounted on a substrate, and a metal enclosure comprising a first housing component welded to a second housing component.

In accordance with a further aspect of the invention, an electrically conductive strip is electrically connected to the substrate on which the electrically component is mounted and has an end disposed between abutting surfaces of the housing components to provide a ground path between the electrical component and the housing.

In accordance with another aspect of the invention, housing components defining a sealed enclosure for an electronic component are configured to retain edges of a substrate on which the electronic component is mounted between the housing components.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a cross section of a portion of a sealed housing in accordance with the invention showing the weld joint between a metal housing cover and a metal housing base.
FIG. 2 is a cross-sectional, elevational view of a sealed electronic component in accordance with the invention.
FIG. 3 is a cross-sectional, elevational view of a sealed electronic component in accordance with an alternative embodiment of the invention in which the cover includes nubs that engage opposite edges of the substrate to provide a thermal conduction path from the substrate to the housing and/or an electrical ground path.
FIG. 4 is a perspective view of a section of the housing cover used in the embodiment of the invention shown in FIG. 4.
FIG. 5 is a partial cross-sectional elevational view of a sealed electronic component in accordance with a further aspect of the invention in which thermally and/or electrically conductive pads are deposited on edges of the substrate to provide a thermal conduction path from the substrate to the housing and/or an electrical ground path.
FIG. 6 is perspective view of a section of the sealed electronic component shown in FIG. 5, with the cover removed.

### Description of the Preferred Embodiments

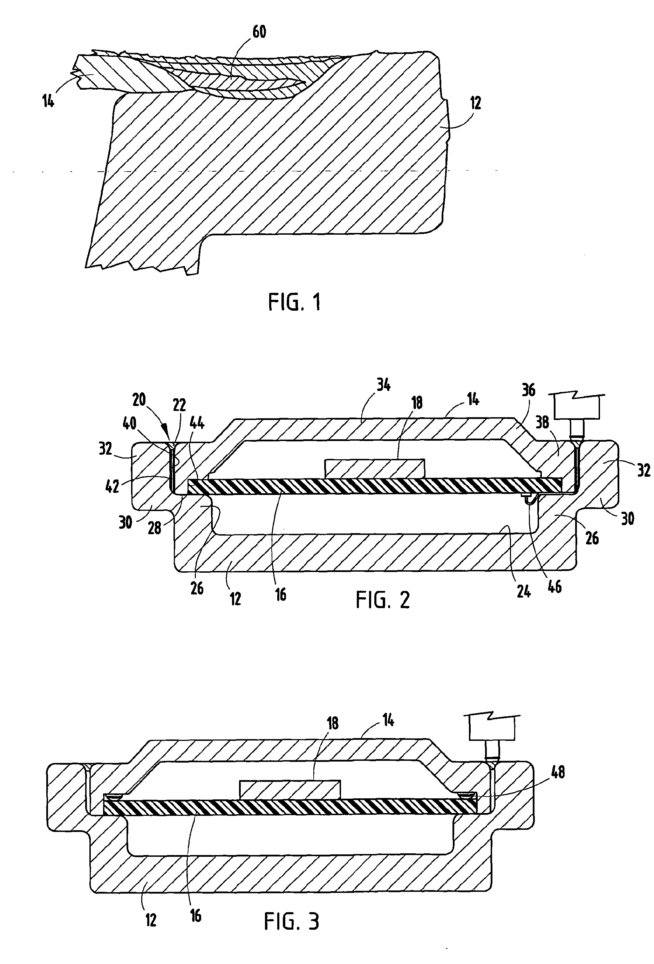

Shown in FIG. 2 is a cross-sectional view of a sealed electronic component in accordance with certain aspects of the invention. The device includes a housing comprising a housing base 12, a housing cover 14, and a substrate 16 on which an electrical component 18 is mounted. Housing base 12 and housing cover 14 are configured to fit together to form a complete enclosure, with abutting surfaces of housing base and housing cover 14 defining a perimeter seam 20. Housing base 12 and housing cover 14 are welded together along the peripheral seam 20 to provide a weld joint 22 (shown on only one side of the sealed electronic component shown in FIG. 2) that hermetically seals the hosing to prevent infiltration of water that could cause deterioration or damage to electric component 18.

In accordance with certain aspects of the invention, housing base 12 and/or housing cover 14 are configured to define a groove or recess in the interior walls at opposite ends of the housing for securely retaining opposite edges of substrate 16. For example, in the embodiment illustrated in FIG. 2, housing base 12 includes a floor portion 24, lower wall portions 26 that project upwardly from floor portion 24 and have an upper surface or ledge 28 on which substrate 16 and housing cover 14 are seated. Housing base 12 also includes a lateral leg portion 30 and an upper wall section 32 that extends upwardly from lateral leg portion 30. In the illustrated embodiment, lower wall section 26 and upper wall section 32 extend around the entire perimeter of the housing. Housing cover 14 includes a roof portion 34, a lateral leg portion 36 that extends downwardly and outwardly from roof portion 34, and a wall portion 38 that projects downwardly from lateral leg portion 36. In the illustrated embodiment, lateral leg portion 36 and wall portion 38 extend around the perimeter of housing cover 14, with a bottom surface of wall portion 38 of housing cover 14 seated on ledge 28 of housing base 12, and with outer wall surface 40 of housing cover 14 being in very close proximity to inner wall surface 42 of upper wall section 32 around the perimeter of the housing to define seam 20.

In the illustrated embodiment, an inner corner of wall portion 38 of housing cover 14 is notched out to define a groove or recess 44, which preferably extends around an inner perimeter of the housing, and is defined between housing base 12 and housing cover 14. Groove or recess 44 is configured to receive and retain edges of substrate 16 to hold substrate 16 and electrical component 18 attached to substrate 16 in a fixed position within the housing. While, in the illustrated and preferred embodiments, groove or recess 44 is defined by a notched-out region of housing cover 14, it will be appreciated that as an alternative, groove or recess 44 may be defined by a notched-out region in housing base 12, or by a combination of notched-out regions in both housing base 12 and housing cover 14.

It will be appreciated that the terms "cover" and "base" are relatively arbitrary terms which refer to the orientation of the housing components in the illustrated embodiments, it being understood that the illustrated assembly may be mounted in a vehicle or other environment in generally any orientation, such that housing component 12 is on top of housing component 14, in which case housing component 12 may be regarded as a cover, and housing component 14 maybe regarded as a base. Further, it should be understood that electronic component 18 may be mounted on either or both sides of substrate 16.

Housing components 12 and 14 may be composed of generally any metal or metal alloy. However, in the preferred embodiments, housing base 12 is a die cast aluminium or aluminium alloy component, and housing cover 14 is a stamped aluminium or aluminium alloy sheet material. Aluminium and aluminium alloy housing components are preferred because these materials can be easily and inexpensively bonded together using a friction stir welding technique. However, generally any metallic material, such as metals, metal alloys or metal composites (e.g., fiber-reinforced metals and/or alloys) can be employed. Further, it is conceivable that the housing components can be made of the same or different metallic materials, and that these compounds can be fabricated using the same or different techniques, such as die casting, sand casting, lost mold casting, forging, stamping, etc.

In a preferred embodiment, housing base 12 and housing cover 14 are joined and sealed together along seam 20 with weld joint 22 that is produced by a friction stir welding technique. In friction stir welding, a tool with a probe attached to its tip is rotated at a high speed while being pushed against the butt sections of the pieces of metal to be welded. The frictional heat generated by this process softens the metal to produce a plastic flow that effectively stirs the metal from the sections on both sides and melts the pieces together to create a weld. Unlike fusion welding, friction stir welding is a solid phase welding method which produces a weld joint having excellent mechanical properties. Friction stir welding has several advantages. First, it creates a hermetic seal between a stamped aluminium or aluminium alloy housing component and a die cast aluminium or aluminium alloy housing component. Further, unlike with fusion welding techniques, weld joints having excellent mechanical properties can be achieved between components composed of different metals or metal alloys. The strong and durable weld joint between the housing components eliminates the need for mechanical fasteners such as threaded screws or the like. It also eliminates the need for dispensing adhesives and for curing adhesives, thereby reducing capital equipment and energy costs. Friction stir welding also produces a reliable weld joint that is not susceptible to failure, and which provides improved electromagnetic compatibility. In fact, the high reliability of the weld joint produced by friction stir welding is expected to eliminate the need for leak testing after assembly.

FIG. 1 is a cross-sectional view of a weld joint produced between a die cast aluminium alloy component 12 and a stamped aluminium alloy sheet component 14. The weld zone 60 has a relatively fine grain structure (determined by optical microscopy) as compared with fusion weld joints, thereby providing excellent mechanical properties.

Electronic component 18 may be generally any type of electronic device, such as semi-conductor devices (e.g., flip chips).

Substrate 16 is generally any substantially flat sheet of material on which conductive paths can be provided and electronic components can be mounted. Examples include printed circuit boards, silicon wafers, etc. By configuring the housing components to define a groove or recess for receiving and firmly holding substrate 16 in place within the housing, the need for mechanical fasteners or other devices for holding substrate 16 in place is eliminated.

In accordance with another aspect of the invention, substrate 16 is grounded to the housing without mechanical fasteners, such as threaded screws, rivets or the like. This objective may be achieved by electrically connecting a ribbon conductor, such as at one end, to substrate 16, and deposing another end of ribbon conductor 46 in seam 20 between outer wall surface 40 of housing component 14 and inner wall surface 42 of housing component 12. The expression "ribbon conductor" refers to an electrically conductive thin strip of material that can be electrically connected, such as by soldering, to circuitry on substrate 16.

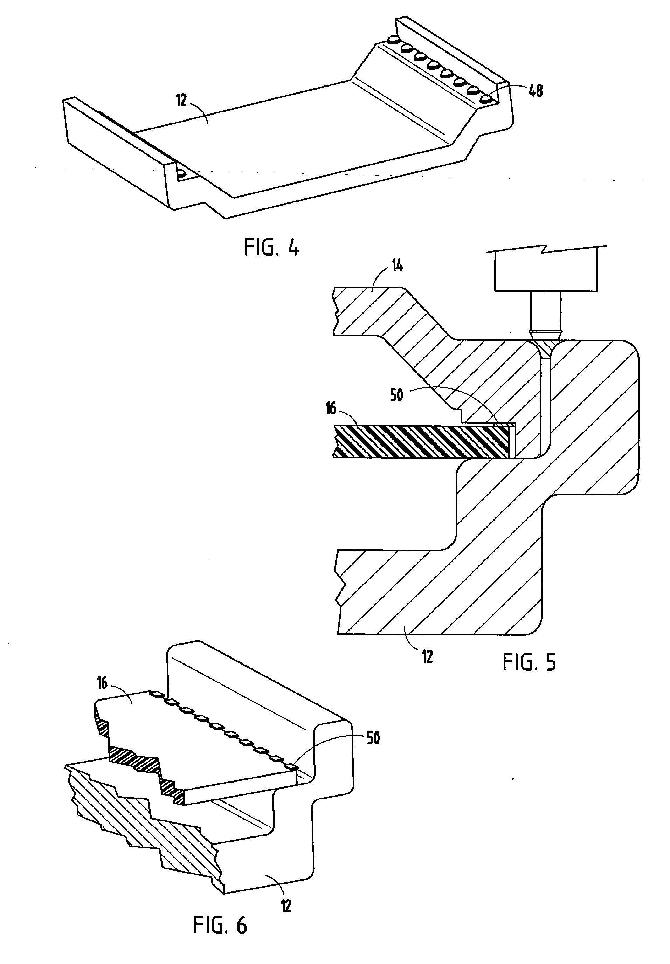

Shown in FIGS. 3 and 4 is an alternative embodiment of the invention, in which housing cover 14 is stamped or shaped to include nubs 48 which provide electrically and/or thermally conductive pathways between the substrate and the housing. In the finished assembly, nubs 48 are compressed or pinched against substrate 16 to provide excellent contact for thermal and/or electrical conduction. As an alternative, nubs 48 may be deposited on housing component 14 such as in the form of copper beads.

FIGS. 5 and 6 illustrate an alternative technique for providing electrically and/or thermally conductive pathways between substrate 16 and the housing. In this embodiment, elastically conductive pads 50 are deposited along the upper edges of substrate 16. In the finished assembly, pads 50 are compressed or pinched between substrate 16 and housing component 14 to provide excellent contact for thermal and/or electrical conduction between substrate 16 and the housing.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. An assembly for a sealed electronic component, comprising:
at least one electronic device (18); and
a metal enclosure including at least a first housing component (12) welded to at least a second housing component (14) to define a sealed enclosure, the electronic device (18) contained within the sealed enclosure.

2. The assembly of claim 1, wherein the metal enclosure consists of a housing cover (14) welded to a housing base (12).

3. The assembly of claim 1, wherein the housing components (12, 14) are stir welded together.

4. The assembly of claim 1, wherein the housing components (12, 14) are composed of aluminium or an aluminium alloy.

5. The assembly of claim 1, wherein one of the housing components (12, 14) is a die cast component and the other housing component (14, 12) is a stamped sheet metal component.

6. The assembly of claim 1, wherein both housing components (12, 14) are stamped sheet metal components.

7. The assembly of claim 1, wherein both housing components (12, 14) are die cast components.

8. The assembly of claim 1, wherein one of the housing components (12, 14) is an aluminium or an aluminium alloy die casting and the other housing component (14, 12) is a stamped aluminium or aluminium alloy sheet material.

9. The assembly of claim 1, wherein the electronic component (18) is mounted on a substrate (16), and the housing components (12, 14) are configured to engage and retain edges of substrate (16) between the housing components (12, 14), and thereby immobilize the electronic component (18) and substrate (16) with respect to the enclosure.

10. The assembly of claim 9, further comprising an electrically conductive strip (46) electrically connected to the substrate (16) and having an end disposed between abutting surfaces of the housing components (12, 14), thereby providing an electrical ground path between the substrate (16) and the housing.

11. The assembly of claim 9, in which electrically and/or thermally conductive pads (50) are deposited along the edges of the substrate (16) retained between the housing components (12, 14).

12. The assembly of claim 9, in which thermally and/or electrically conductive nubs (48) are formed or deposited on a surface of at least one of the housing components (12, 14) that engages an edge of the substrate (16).

13. The assembly of claim 1, wherein the first housing component (12) is welded to the second housing component (14) by a weld joint (22) produced using a friction stir welding technique.

14. A process for sealing an electronic component in a housing, comprising:
mounting at least one electronic device (18) on a substrate (16);
placing the substrate (16) on or in a first housing component (12);
providing a second housing component (14) having surfaces configured to engage surfaces of the first housing component (12) to define an enclosure for the substrate (16) and at least one electronic device (18) mounted on the substrate (16), the abutting surfaces defining a seam (20); and
welding the housing components (12, 14) together along the seam (20) to define a sealed enclosure.

15. The process of claim 14, wherein the metal enclosure consists of a housing cover (14) welded to a housing base (12).

16. The process of claim 14, wherein the housing components (12, 14) are friction stir welded together.

17. The process of claim 14, wherein the housing components (12, 14) are composed of aluminium or an aluminium alloy.

18. The process of claim 14, wherein one of the housing components (12, 14) is a die cast component and the other housing component (14, 12) is a stamped sheet metal component.

19. The process of claim 14, wherein both housing components (12, 14) are stamped sheet metal components.

20. The process of claim 14, wherein both housing components (12, 14) are die cast components.

21. The process of claim 14, wherein one of the housing components (12, 14) is an aluminium or an aluminium alloy die casting and the other housing component (14, 12) is a stamped aluminium or aluminium alloy sheet material.

22. The process of claim 14, wherein the housing components (12, 14) are configured to engage and retain edges of the substrate (16) between the housing components (12, 14), and thereby immobilize the electronic component (18) and substrate (16) with respect to the enclosure.

23. The process of claim 14, further comprising an electrically conductive strip (46) electrically connected to the substrate (16) and having an end disposed between abutting surfaces of the housing components (12, 14), thereby providing an electrical ground path between the substrate (16) and the housing.

24. The process of claim 14, wherein the first housing component (12) is welded to the second housing component (14) by a weld joint (22) produced using a friction stir welding technique.

25. The process of claim 14, in which electrically and/or thermally conductive pads (50) are deposited along the edges of the substrate (16) retained between the housing components (12, 14).

26. The process of claim 14, in which thermally and/or electrically conductive nubs (48) are formed or deposited on a surface of at least one of the housing components (12, 14) that engages an edge of the substrate (16).
